# EUROPEAN PATENT SPECIFICATION

(11) **EP 1 995 464 B1**
(45) Date of publication and mention of the grant of the patent: **20.03.2013**
(21) Application number: 06728838.1
(22) Date of filing: 09.03.2006
(51) Int. Cl.: G06F 1/20, H05K 7/20

(54) **FAN APPARATUS, ELECTRONIC APPARATUS, AND CONTROL METHOD FOR THEM**
LÜFTERVORRICHTUNG, ELEKTRONISCHE VORRICHTUNG UND STEUERVERFAHREN DAFÜR
VENTILATEUR, APPAREIL ÉLECTRONIQUE, ET LEUR PROCÉDÉDE DE COMMANDE

(43) Date of publication of application: 26.11.2008
(73) Proprietor: Fujitsu Ltd., Kawasaki-shi, Kanagawa 211-8588 (JP)
(72) Inventor: NISHIZAWA, Masatoshi, Kawasaki-shi, Kanagawa 2118588 (JP); HARADA, Tomoki, Kawasaki-shi, Kanagawa 2118588 (JP); NAKAGAI, Goro, Kawasaki-shi, Kanagawa 2118588 (JP); KATO, Toyohiro, Kawasaki-shi, Kanagawa 2118588 (JP)
(74) Representative: Holtby, Christopher Lawrence
(86) International application number: PCT/JP2006/304621
(87) International publication number: WO 2007/102226

(56) References cited:
- EP-A- 1 798 629
- WO-A-02/103505
- WO-A1-2004/059174
- JP-A- 8 162 789
- JP-A- 2000 153 121
- JP-A- 2000 153 121
- JP-A- 2000 325 720
- JP-A- 2002 062 589
- JP-A- 2004 063 993
- US-A- 6 118 654
- US-A1- 2002 101 714
- US-A1- 2003 024 683
- US-A1- 2004 123 978

## Description

### FIELD OF THE INVENTION

The present invention relates to a fan unit including a fan generating airflow.

### BACKGROUND ART

A fan is incorporated in a water heater as disclosed in Patent Publication 1, for example. The actual rotation speed of the fan is compared with a designated rotation speed of the fan for detection of a failure in the fan. When the actual rotation speed is significantly lower than the designated rotation speed, a failure in the fan based on occlusion of a ventilation opening, and/or deterioration of the fan is detected.
Patent Publication 1:
JP Patent Application Publication No. 8-178273
Patent Publication 2:
JP Patent Application Publication No. 2005-4675
Patent Publication 3:
JP Patent Application Publication No. 9-1824189
Patent Publication 4:
JP Patent Application Publication No. 2004-263989

A centrifugal fan is often utilized in a so-called notebook personal computer for cooling a central processing unit, CPU, for example. The inventors tried to detect occlusion of the ventilation opening of the centrifugal fan in the aforementioned manner. Dust was deliberately cumulated so that the ventilation opening is occluded. However, it has been confirmed that it is impossible to detect the occlusion of the ventilation opening in the aforementioned manner.

It is accordingly desirable to provide a fan unit and an electronic apparatus, capable of detection of occlusion of a ventilation opening of a centrifugal fan. [0004a] United States Patent Application publication Number 2002/101714 A1 discloses a computer system configured to remove a cooling fan obstruction by manipulating the rotation speed of the fan. The fan speed is used as an indication of an obstruction. The detection of the obstruction leads to stopping and restarting of the fan or reversing of the rotation of the fan.
[0004b] United States Patent Application publication Number 2003/024683 A1 discloses a display device configured to detect the clogging of an air filter and to inform a user of the clogging of the air filter. As depicted in FIG. 1 of US 2003/024683, a current detecting resistor is inserted between a suction fan and a power supply. Potentials V1 and V2 at both the ends of the current detecting resistor are input into a CPU through an A/D converter. The CPU reads the potentials V1 and V2 at both ends of the current detecting resistor, and the CPU judges whether or not a potential difference (V1-V2) is not more than a predetermined reference value. When the potential difference (V1-V2) is not more than the predetermined reference value, it is judged that the air filter is clogged. A lamp switch is correspondingly turned off and a light emitting diode is turned on. In this manner, a user is informed that the air filter is clogged.
[0004c] Japanese Patent Application Publication Number 2002062589 discloses an image projecting apparatus configured to detect the clogging of a filter. A controller counts rotation signals output from a motor of a fan through a (third) signal line for a predetermined period of time and compares the number of counts with a predetermined value. When the number of counts is equal to or less than the predetermined value, it is judged that the filter is not clogged. When the number of counts exceeds the predetermined value, a warning section outputs a warning message. In this manner, a user can be notified of the optimal time for the replacement of the filter.
[0004d] Japanese Patent Application Publication Number 2000153121 discloses a clogging detection controller circuit configured to judge whether or not a filter is clogged. The rotation speed of a drive motor of a fan is detected so as to judge whether or not the filter is clogged. When the filter is clogged, airflow introduced into the fan is reduced. A load to the drive motor is reduced. The rotation speed of the drive motor is thus increased. A reference value of the rotation speed is set to correspond to the rotation speed of the motor when the filter suffers from no clogging. When the rotation speed gets larger than the reference value by a predetermined value, a user is informed that the filter is clogged and/or the operation of the drive motor is stopped.

### DISCLOSURE OF THE INVENTION

A fan unit is proposed which comprises: a fan generating airflow through the rotation of a rotor, the fan comprising a centrifugal fan; a rotation speed detector circuit connected to the fan, the rotation speed detector circuit detecting the actual rotation speed of the rotor; and a deviation detector circuit detecting a deviation between the actual rotation speed and a designated rotation speed specified in a control signal supplied to the fan, the deviation detector circuit outputting a predetermined signal when the actual rotation speed exceeds the designated rotation speed by a predetermined amount.

The inventors have revealed that the actual rotation speed of the rotor in the fan exceeds the designated rotation speed if the ventilation opening of the fan is occluded. If a larger amount of dust cumulates at the ventilation opening of the fan, for example, the actual rotation speed of the rotor in the fan exceeds the designated rotation speed by a predetermined amount. The deviation detector circuit detects the deviation. The deviation detector circuit outputs a predetermined signal. The cumulation of dust at the ventilation opening can in this manner be detected in a facilitated manner. The occlusion of the ventilation opening can thus be detected.

For controlling the fan unit, there may be provided a method comprising: supplying a control signal to a fan generating airflow through the rotation of a rotor for specifying a designated rotation speed of the rotor; detecting the actual rotation speed of the rotor; detecting a deviation between the designated rotation speed and the actual rotation speed; and outputting a predetermined signal when the actual rotation speed exceeds the designated rotation speed by a predetermined amount, wherein the fan comprises a centrifugal fan.

The fan unit may be incorporated in an electronic apparatus. The electronic apparatus may comprise an enclosure and a fan enclosed in the enclosure. The fan may have a ventilation opening for discharge of air, may generate airflow through the rotation of a rotor, and may comprise a centrifugal fan. The electronic apparatus may also comprise a rotation speed detector circuit connected to the fan, the rotation speed detector circuit detecting the actual rotation speed of the rotor; and a deviation detector circuit detecting a deviation between the actual rotation speed and a designated rotation speed specified in a control signal supplied to the fan, the deviation detector circuit outputting a predetermined signal indicating possible occlusion of the ventilation opening when the actual rotation speed exceeds the designated rotation speed by an amount equal to or larger than a threshold. The electronic apparatus may further comprise a storage circuit including a data table, the data table holding values of the designated rotation speed and the threshold for various temperatures; and the deviation detector circuit may obtain the threshold out of the data table in accordance with the level of a temperature specified in a temperature information signal. The electronic apparatus may allow detection of occlusion of the ventilation opening in the same manner as described above.

The electronic apparatus may further comprise: a dust catcher located in an air passage extending from the ventilation opening; and the deviation detector circuit may output the predetermined detection signal to indicate possible occlusion of the ventilation opening or accumulation of a predetermined amount of dust at the dust catcher.

The inventors have revealed that the actual rotation speed of the rotor in the fan exceeds the designated rotation speed if the ventilation opening of the fan is occluded. The dust catcher may be located in the air passage extending from the ventilation opening of the fan. If a larger amount of dust cumulates at the dust catcher, for example, the ventilation opening of the fan may be occluded. The actual rotation speed of the rotor in the fan may thus exceeds the designated rotation speed by a predetermined deviation. The deviation detector circuit detects the deviation. The deviation detector circuit outputs a predetermined signal. The accumulation of dust at the ventilation opening can in this manner be detected in a facilitated manner. The accumulation of dust at the dust catcher or occlusion of the ventilation opening can thus be detected.

For controlling the electronic apparatus of the type, there may be provided a method of controlling an electronic apparatus, comprising: supplying a control signal to a fan for specifying a designated rotation speed of a rotor rotating to generate airflow toward a dust catcher located in an air passage extending from the fan; detecting the actual rotation speed of the rotor; detecting a deviation between the designated rotation speed and the actual rotation speed; and outputting a predetermined detection signal for detection of occlusion of a predetermined amount of dust at the dust catcher when the actual rotation speed exceeds the designated rotation speed by a predetermined amount. In this case, the fan is made of a centrifugal fan.

### BRIEF DESCRIPTION OF THE DRAWINGS

Fig. 1 is a perspective view schematically illustrating a notebook personal computer as a specific example of an electronic apparatus according to the present invention.
Fig. 2 is a perspective view schematically illustrating the bottom surface of a main body.
Fig. 3 is an enlarged partial perspective view schematically illustrating the inner structure of the main body.
Fig. 4 is a partial sectional view schematically illustrating the structure of a cooling apparatus.
Fig. 5 is a perspective view schematically illustrating the structure of a dust catcher.
Fig. 6 is a block diagram schematically illustrating a control system of the notebook personal computer.
Fig. 7 is an enlarged partial sectional view taken along the line 7-7 in Fig. 4.
Fig. 8 is a partial sectional view, corresponding to Fig. 4, for schematically illustrating the cooling apparatus in operation.
Fig. 9 is an enlargedpartial sectional view, corresponding to Fig. 7, for schematically illustrating the removal of the dust catcher from the main body.
Fig. 10 is an enlarged partial sectional view, corresponding to Fig. 7, for schematically illustrating the removal of the dust catcher from the main body.

### BEST MODE FOR CARRYING OUT THE INVENTION

Description will be made below on an embodiment of the present invention with reference to the attached drawings.

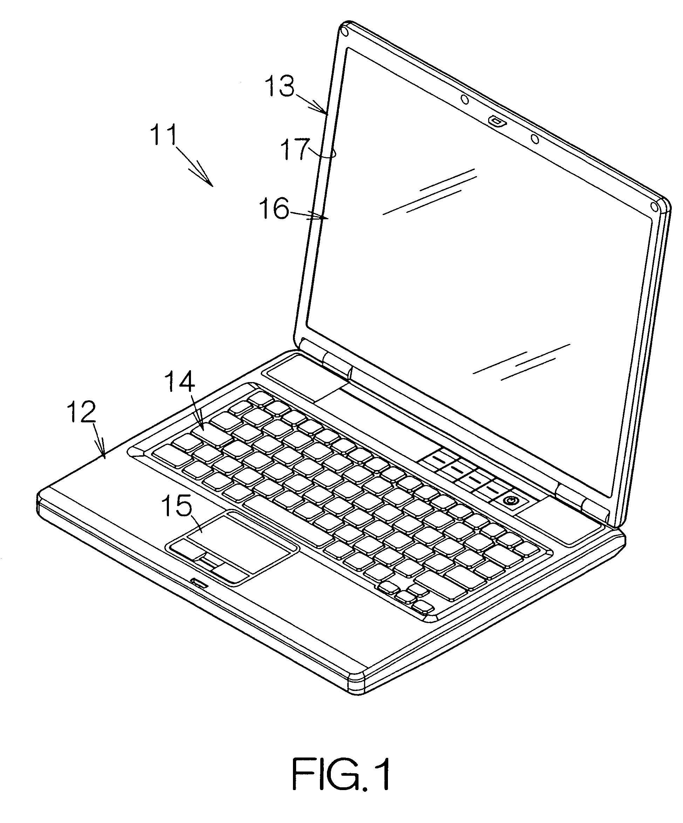

Fig. 1 schematically illustrates a notebook personal computer 11 as a specific example of an electronic apparatus according to the present invention. The notebook personal computer 11 includes a thin main body 12 and a display enclosure 13 pivotably coupled to the main body 12. Input devices such as a keyboard 14 and a pointing device 15 are embedded in the front surface of the main body 12. Users manipulate the keyboard 14 and/or the pointing device 15 to input commands and/or data.

A display device such as a liquid crystal display (LCD) panel module 16 is enclosed in the display enclosure 13, for example. The screen of the LCD panel module 16 gets exposed in a window opening 17 defined in the display enclosure 13. Text data and graphics are displayed on the screen. Users can see the ongoing operation of the notebook personal computer 11 based on the displayed text data and graphics. The display enclosure 13 can be superimposed on the main body 12 through a pivotal movement relative to the main body 12.

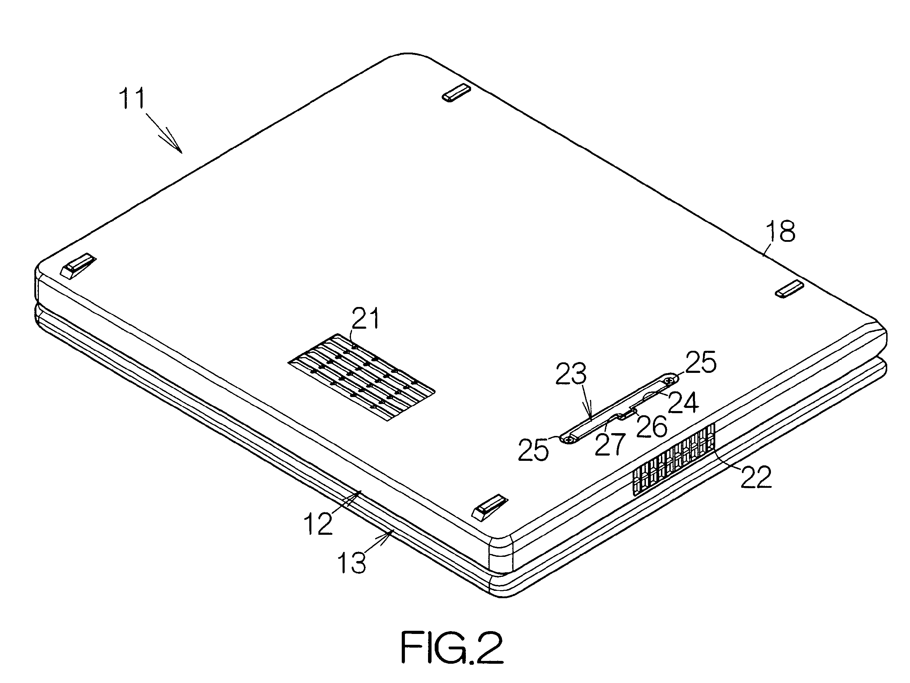

As shown in Fig. 2, an air inlet 21 and an air outlet 22 are defined in the enclosure 18 of the main body 12. The air inlet 21 may be defined in the bottom plate of the enclosure 18, for example. The air outlet 22 may be defined in the side wall standing upright from the outer periphery of the bottom plate of the enclosure 18, for example. Fresh air is introduced through the air inlet 21 into the inner space of the enclosure 18 from the outer space of the enclosure 18. Air is discharged through the air outlet 22 from the inner space of the enclosure 18 into the outer space of the enclosure 18. When the notebook personal computer 11 is set on a desk, the bottom plate is usually opposed to the upper surface of the desk. The air outlet 22 is thus prevented from being blocked.

A dust catcher 23 is removably mounted in the bottom plate of the enclosure 18 from the outside of the enclosure 18. An opening or slot 24 is defined in the bottom plate of the enclosure 18 for receiving the dust catcher 23. The dust catcher 23 is inserted into the inner space of the enclosure 18 through the slot 24. The dust catcher 23 is fixed to the bottom plate of the enclosure 18. A pair of screws 25 is utilized to fix the dust catcher 23, for example. The screws 25 are screwed into the bottom plate of the enclosure 18.

The dust catcher 23 includes a lug 26. The lug 26 is held in a depression 27 defined in the bottomplate of the enclosure 18. The depression 27 is formed continuous to the slot 24. Users can hook the lug 26 with a finger when they intend to remove the dust catcher 23, for example. The dust catcher 23 will be described later in detail.

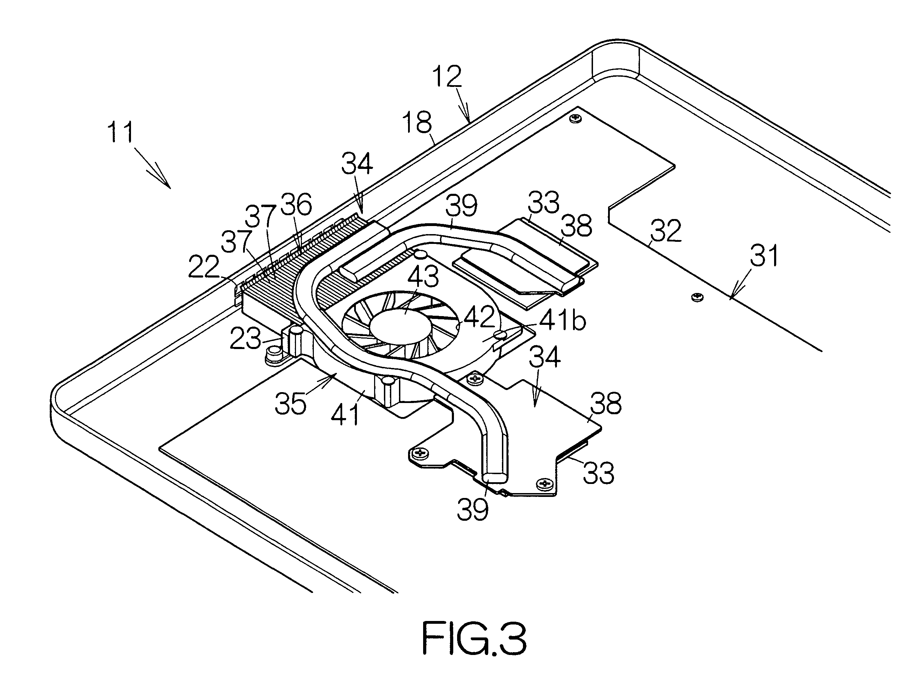

As shown in Fig. 3, a printed circuit board unit 31 is enclosed in the enclosure 18 of the main body 12. The printed circuit board unit 31 includes a printed wiring board 32 and large-scale integrated circuit (LSI) packages 33, 33 mounted on the surface of the printed wiring board 32. The individual LSI package 33 includes a central processing unit (CPU) chip or a video chip, both not shown, mounted on a small-sized ceramic substrate, for example. The CPU chip executes various kinds of processing based on an operating system (OS) and application software, for example. The video chip executes various kinds of image processing in response to the instructions from the CPU chip, for example.

A cooling apparatus 34 is coupled to the LSI packages 33. The cooling apparatus 34 includes a fan unit 35. A heat radiating fin member 36 is located in a space between the fan unit 35 and the air outlet 22. The heat radiating fin member 36 includes heat radiating fins 37 extending in parallel with one another. Air passages are defined between individual adjacent ones of the heat radiating fins 37. The fan unit 35 serves to generate airflow running through the air passages to the air outlet 22. The airflow serves to discharge heat of the heat radiating fins 37 out of the enclosure 18.

Heat conductive plates 38 are respectively superimposed on the CPU chip and the video chip. A heat conductive member or heat pipe 39 is utilized to connect the individual heat conductive plate 38 and the heat radiating fins 37. Heat is transferred from the heat conductive plate 38 to the heat radiating fins 37 through the heat pipe 39. The heat conducive plates 38 are designed to receive heat from the CPU chip and the video chip.

The fan unit 35 includes a fan housing 41. The fan housing 41 defines a predetermined inner space. Air suction openings 42, only one shown, are formed in the fan housing 41. The air suction openings 42 serve to connect the inner space to the outside of the fan housing 41. A fan 43 is enclosed in the fan housing 41.

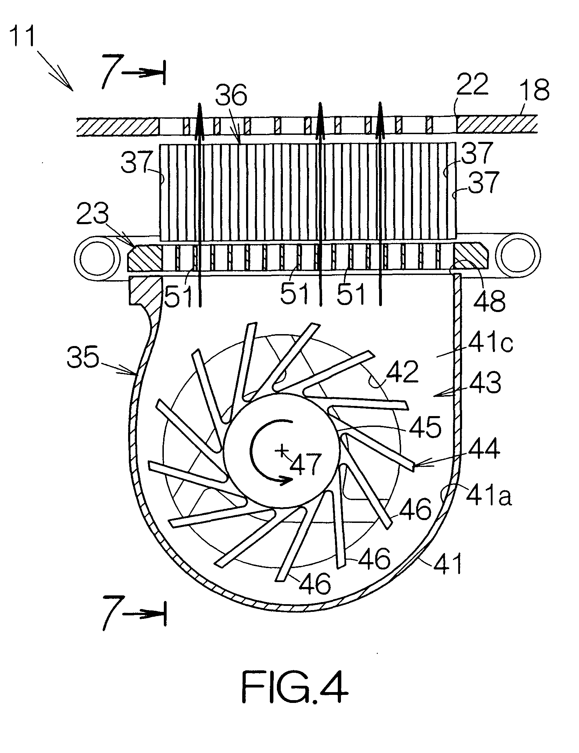

As shown in Fig. 4, a so-called centrifugal fan is employed as the fan 43. The fan 43 includes a rotor 44. The rotor 44 includes a rotating body 45 and blades 46 extending in the radial or centrifugal directions from the rotating body 45 around the rotating body 45. When the rotor 44 is driven to rotate around a rotation axis 47, air is introduced along the rotation axis 47 through the air suction openings 42. The rotation of the blades 46 generates airflow in the centrifugal direction.

The fan housing 41 defines a surrounding side wall 41a, a top plate 41b (shown in Fig. 3) and a bottom plate 41c. The surrounding side wall 41a is located at a position outside the rotor 44 in the centrifugal direction. The top plate 41b and the bottom plate 41c are coupled to the upper and lower ends of the surrounding side wall 41a, respectively. The inward surface of the surrounding side wall 41a is opposed to the outer ends of the blades 46 of the rotor 44. The air suction opening 42 is defined in each of the top plate 41b and the bottom plate 41c. The surrounding side wall 41a has a gap for defining a ventilation opening 48 between the top plate 41b and the bottom plate 41c. The ventilation opening 48 is located at a position outside the rotor 44 in the centrifugal direction.

The ventilation opening 48 is opposed to the heat radiating fin member 36 at a distance. The centrifugal airflow is guided to the ventilation opening 48 along the inward surface of the surrounding side wall 41a. The airflow is then discharged through the ventilation opening 48. The heat radiating fin member 36 serves to guide the airflow to the air outlet 22. In other words, the heat radiating fin member 36 defines an air passage extending from the ventilation opening 48 to the air outlet 22. The heat radiating fins 37 are located within the air passage.

As is apparent from Fig. 4, the dust catcher 23 is located within the air passage between the ventilation opening 48 or fan 43 and the heat radiating fins 37. The dust catcher 23 includes parallel members 51 located at positions adjacent to the upstream edges of the heat radiating fins 37. The parallel members 51 may be small plates extending in parallel with one another. The parallel members 51 are designed to extend along imaginary planes including the heat radiating fins 37. The downstream edges of the parallel members 51 may be continuous with the upstream edges of the corresponding heat radiating fins 37. At least the upstream edges of the heat radiating fins 37 are hidden from the airflow behind the parallel members 51.

The number of parallel members 51 may depend on the thickness of the individual parallel member 51. Additionally, the number of parallel members 51 may also depend on the size of pieces of captured dust, the amount of airflow for sufficiently cooling the heat radiating fins 37, or the like. Here, the parallel members 51 are assigned to every other heat radiating fin 37. The spaces between the parallel members 51 are thus set wider or larger than the spaces between the heat radiating fins 37. A relatively large-sized trash such as a piece of thread can be attached to the parallel members 51. Such a trash is prevented from getting into the heat radiating fin member 36. Simultaneously, a relatively small-sized trash such as dust can pass through the spaces between the parallel members 51 as well as the spaces between the heat radiating fins 37. Such a trash is discharged out of the air outlet 22. A relatively small-sized trash is also attached to the parallel members 51.

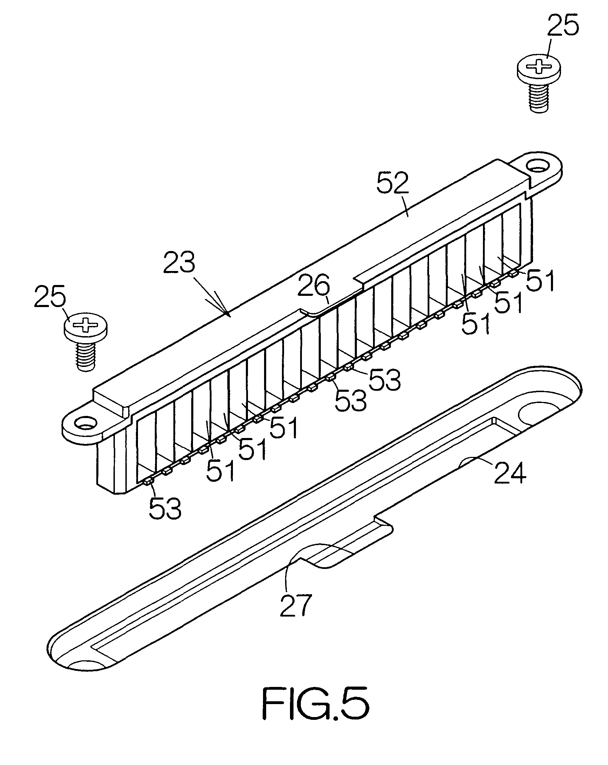

As shown in Fig. 5, the dust catcher 23 includes a frame 52 holding the parallel members 51. The frame 52 defines an air passage in a space between the ventilation opening 48 and the heat radiating fin member 36. The parallel members 51 are located within the air passage. The frame 52 and the parallel members 51 may be formed in a one piece component made of a resin material, for example. Molding process may be employed to form such a one piece component, for example.

Here, asperity may be established on the upstream edges of the parallel members 51. A number of particles may be adhered to the surfaces of the parallel members 51 for establishing the asperity. Alternatively, a mold for forming the parallel members 51 may have an asperity, reflecting an asperity of the parallel members 51, on the inward surface of the cavity. Otherwise, the surfaces of the parallel members 51 may be subjected to abrasion with sandpaper, for example. A light tackiness may be added to the surfaces of the parallel members 51 instead of the asperity. A coating film serves to establish the light tackiness, for example.

Hook members 53 may be formed on the frame 52. The hook members 53 are designed to protrude downstream from the frame 52. The hook members 53 may be located in the intermediate positions between adjacent ones of the parallel members 51, respectively. The individual hook member 53 may be formed in the shape of a small parallelepiped, for example. The hook members 53 may be formed integral with the frame 52 based on molding. Asperity may also be established on the surfaces of the hook members 53.

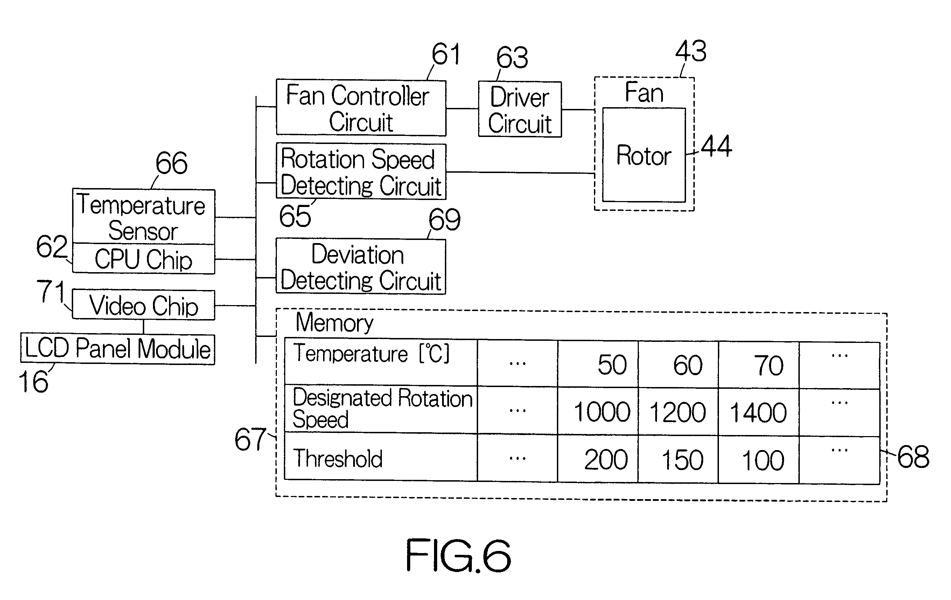

As shown in Fig. 6, the notebook personal computer 11 may include a fan controller circuit 61. The fan controller circuit 61 is designed to control the rotation speed of the rotor 44 of the fan 43 in accordance with the level of the temperature of the central processing unit (CPU) chip 62. A control signal is generated at the fan controller circuit 61 for controlling the rotation speed. A designated rotation speed of the rotor 44 is specified in the control signal.

A driver circuit 63 is connected to the fan controller circuit 61. An electric motor of the fan 43 is connected to the driver circuit 63. The driver circuit 63 is designed to control the electric motor based on the duty ratio and/or the voltage value. The drive circuit 63 generates a drive signal based on the control signal from the fan controller circuit 61. The drive signal reflects the designated rotation speed specified in the control signal. The fan 43 in this manner generates airflow through the rotation of the rotor 44.

A rotation speed detector circuit 65 such as an encoder is connected to the fan controller circuit 61. The rotation speed detector circuit 65 is designed to detect the actual rotation speed of the rotor 44. A rotation speed information signal is generated in the rotation speed detector circuit 65. The actual rotation speed of the rotor 44 may be specified in the rotation speed information signal.

A temperature sensor 66 is connected to the fan controller circuit 61. The temperature sensor 66 is designed to detect the temperature of the CPU chip 62, for example. The temperature sensor 66 may be embedded within the CPU chip 62. The temperature sensor 66 supplies a temperature information signal to the fan controller circuit 61. The temperature of the CPU chip 62 may be specified in the temperature information signal.

A storage circuit such as a memory 67 is connected to the fan controller circuit 61. A data table 68 is established in the memory 67. The data table 68 holds values of a designated rotation speed and a threshold of the rotor 44 for various temperatures of the CPU chip 62. The fan controller circuit 61 selects a designated rotation speed in the data table 68 in accordance with the temperature of the CPU chip 62.

A deviation detector circuit 69 is connected to the fan controller circuit 61. The deviation detector circuit 69 is designed to detect whether or not the actual rotation speed is faster than the selected designated rotation speed. The deviation detector circuit 69 is designed to calculate the deviation or difference between the designated rotation speed and the actual rotation speed. The control signal maybe supplied to the deviation detector circuit 69 from the fan controller circuit 61 for specifying the designated rotation speed. Alternatively, the deviation detector circuit 69 may read the designated rotation speed in the data table 68 based on the temperature information signal. The actual rotation speed may be obtained based on the rotation speed information signal. The deviation detector circuit 69 obtains the corresponding threshold out of the data table 68 in accordance with the level of the temperature specified in the temperature information signal. The deviation between the designated rotation speed and the actual rotation speed is compared with the obtained corresponding threshold.

A video chip 71 is connected to the CPU chip 62. The aforementioned LCD panel module 16 is connected to the video chip 71. When the actual rotation speed deviates from the designated rotation speed by a predetermined amount, the deviation detector circuit 69 supplies a warning signal to the CPU chip 62. The CPU chip 62 executes processing in response to reception of the warning signal. The video chip 71 operates to display predetermined information on the screen of the LCD panel module 16 based on the calculation at the CPU chip 62.

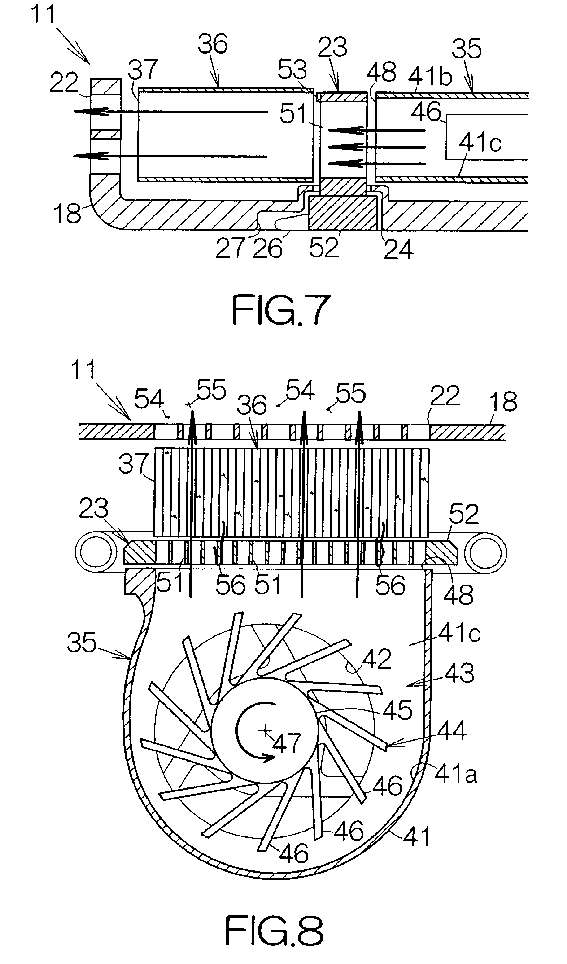

As shown in Fig. 7, when the dust catcher 23 is inserted into the slot 24 from the outside of the enclosure 18, the dust catcher 23 and the heat radiating fin member 36 in combination establish the air passage between the ventilation opening 48 and the air outlet 22. Airflow is discharged through the ventilation opening 48 in response to the supply of electric power to the fan 43. The discharged airflow is guided to the air outlet 22 along the air passage. The airflow is in this manner discharged out of the air outlet 22. Heat can be removed from the heat radiating fins 37 with a higher efficiency. Although the parallel members 51 have a thickness larger than that of the heat radiating fins 37, the heat radiating fins 37 can enjoy a sufficient amount of airflow because sufficient spaces are established between the parallel members 51.

The fan unit 35 serves to suck air within the entire space of the enclosure 18. Dust enters the enclosure 18 through not only the air inlet 21 but also any gaps of the enclosure 18. Such dust can be caught in the airflow discharged from the ventilation opening 48 of the fan unit 35. As shown in Fig. 8, fine dusts 54 and short dusts 55 can pass through the dust catcher 23 and the heat radiating fin member 36. The fine dusts 54 and the short dusts 55 are then discharged out of the air outlet 22. On the other hand, long dusts 56 are captured at the upstream edges of the parallel members 51. The long dusts 56 stepwise cumulate on the parallel members 51 as time elapses.

The rotation of the rotor 44 is controlled in the fan 43. The fan controller circuit 61 detects the temperature of the CPU chip 62 in this case. The fan controller circuit 61 serves to write a designated rotation speed into the control signal based on the temperature information signal. The control signal causes the electric motor to drive the rotor 44 at the designated rotation speed. A rise in the temperature of the CPU chip 62 induces an increase in the rotation speed of the rotor 44. In this manner, the CPU chip 62 is prevented from suffering from a higher temperature.

The rotation speed detector circuit 65 detects the actual rotation speed of the rotor 44. The temperature information signal and the rotation speed information signal are supplied to the deviation detector circuit 69. The deviation detector circuit 69 specifies the designated rotation speed of the rotor 44 in accordance with the level of the temperature of the CPU chip 62. The deviation detector circuit 69 calculates the deviation between the designated rotation speed and the actual rotation speed. The calculated deviation is compared with the threshold.

When the actual rotation speed exceeds the designated rotation speed by a deviation equal to or larger than the threshold, for example, the predetermined warning signal is supplied to the CPU chip 62 from the deviation detector circuit 69. The CPU chip 62 executes processing in response to reception of the warning signal. The video chip 71 executes an image processing based on the calculation at the CPU chip 62. The CPU chip 62 operates to pop up a window of warning on the screen of the LCD panel module 16, for example. The user is recommended to remove the dust catcher 23 for cleaning. The user is in this manner notified of the optimal time for cleaning.

The dust catcher 23 can be removed from the bottom plate of the enclosure 18 as described above. The dust catcher 23 holds the long dusts 56 on the parallel members 51 during the removal. The dusts 56 are thus removed from the air passage along with the dust catcher 23. The long dusts 56 are thus reliably cleared from the air passage. The dust catcher 23 can then be cleaned. The cleaned dust catcher 23 may again be set in the bottom plate of the enclosure 18. Airflow of a sufficient amount is in this manner always kept in the air passage. Heat is thus radiated from the heat radiating fins 37 in an efficient manner.

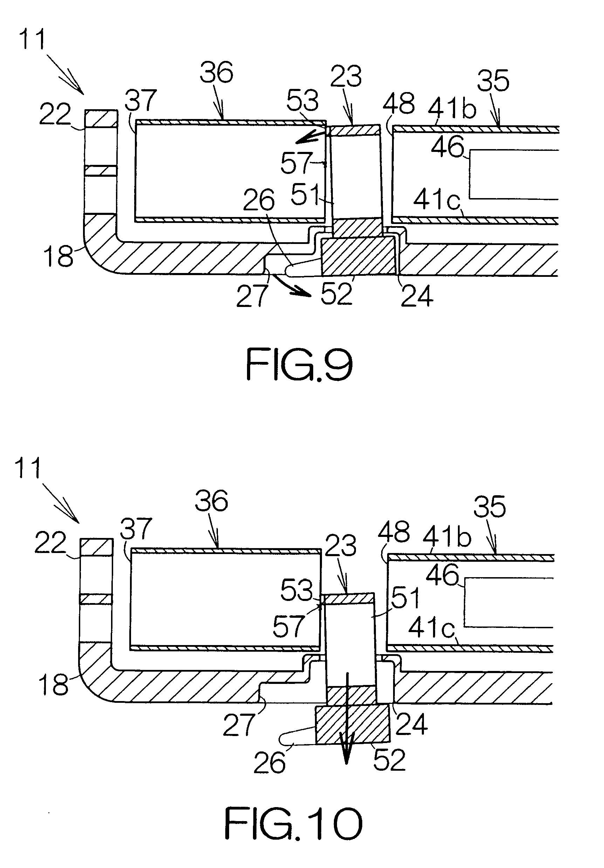

As shown in Fig. 9, users are allowed to hook the lug 26 with a nail or finger when the users intend to remove the dust catcher 23. The frame 52 thus receives a force from the tip or free end of the lug 26. This results in an inclining movement of the frame 52. The hook members 53 are thus brought into contact with the upstream edges of the heat radiating fins 37.

When the dust catcher 23 is subsequently withdrawn from the slot 24, the hook members 53 keep sliding along the corresponding upstream edges of the heat radiating fins 37, as shown in Fig. 10. The hookmembers 53 catch the dusts 57 cumulated at the upstream edges of the heat radiating fins 37. The dusts 57 can in this manner be scraped off the upstream edges of the heat radiating fins 37. The dusts 57 can be removed away from the air passage. Airflow of a sufficient amount is in this manner always kept in the air passage.

The inventors have revealed that the actual rotation speed of the rotor 44 in the fan 43 made of a centrifugal fan exceeds the designated rotation speed if a larger amount of dust cumulates at the dust catcher 23. The hard disk drive 11 allows the actual rotation speed of the rotor 44 to exceed the designated rotation speed by a predetermined amount if dust sufficiently cumulates at the dust catcher 23. The cumulation of dust can in this manner be detected in a facilitated manner. The occlusion of the ventilation opening 48 is reliably prevented. The optimal time for cleaning the dust catcher 23 is specified in a facilitated manner.

The fan unit 35 may allow the CPU chip 62 to take over the processing at the deviation detector circuit 69. In this case, the CPU chip 62 may execute the processing based on a software program.

## Claims

1. An electronic apparatus (11) comprising:
an enclosure (18);
a fan (43) enclosed in the enclosure (18), wherein the fan (43):
has a ventilation opening (48) for discharge of air,
generates airflow through rotation of a rotor (44),
and
comprises a centrifugal fan;
a rotation speed detector circuit (65) connected to the fan (43), the rotation speed detector circuit (65) detecting an actual rotation speed of the rotor (44); and
a deviation detector circuit (69) detecting a deviation between the actual rotation speed and a designated rotation speed specified in a control signal supplied to the fan (43), the deviation detector circuit (69) outputting a predetermined signal indicating possible occlusion of the ventilation opening (48) when the actual rotation speed exceeds the designated rotation speed by an amount equal to or larger than a threshold;
**characterised in that** the electronic apparatus further comprises:
a storage circuit including a data table (68), the data table (68) holding values of the designated rotation speed and the threshold for various temperatures; and
the deviation detector circuit (69) obtains the threshold out of the data table in accordance with the level of a temperature specified in a temperature information signal.

2. The electronic apparatus (11) according to claim 1, wherein:
the electronic apparatus further comprises a dust catcher (23) located in an air passage extending from the ventilation opening (48); and
the deviation detector circuit (69) outputs the predetermined signal to indicate possible occlusion of the ventilation opening (48) or accumulation of a predetermined amount of dust at the dust catcher (23).

## Patentansprüche

1. Elektronische Vorrichtung (11), welche Folgendes umfasst:
ein Gehäuse (18);
einen Lüfter (43) eingeschlossen in dem Gehäuse (18),
wobei der Lüfter (43):
eine Ventilationsöffnung (48) zum Abführen von Luft aufweist,
einen Luftstrom durch Rotation eines Rotors (44) erzeugt, und
einen Fliehkraftlüfter umfasst;
eine Rotationsgeschwindigkeits-Detektorschaltung (65) verbunden mit dem Lüfter (43), wobei die Rotationsgeschwindigkeits-Detektorschaltung (65) eine tatsächliche Rotationsgeschwindigkeit des Rotors (44) erkennt; und
eine Abweichungs-Detektorschaltung (69), welche eine Abweichung zwischen der tatsächlichen
Rotationsgeschwindigkeit und einer bezeichneten Rotationsgeschwindigkeit erkennt, die in einem Steuersignal spezifiziert wird, welches an den Lüfter (43) bereitgestellt wird, wobei die Abweichungs-Detektorschaltung (69) ein vorbestimmtes Signal ausgibt,
welches einen möglichen Verschluss der Ventilationsöffnung (48) anzeigt, wenn die tatsächliche Rotationsgeschwindigkeit die bezeichnete Rotationsgeschwindigkeit um eine Menge übersteigt, die gleich einer oder größer als eine Schwelle ist;
**dadurch gekennzeichnet, dass** die elektronische Vorrichtung ferner Folgendes umfasst:
eine Speicherschaltung, welche eine Datentabelle (68) beinhaltet, wobei die Datentabelle (68) Werte der bezeichneten Rotationsgeschwindigkeit und die Schwelle für verschiedene Temperaturen enthält; und
die Abweichungs-Detektorschaltung (69) die Schwelle in Übereinstimmung mit dem Level einer Temperatur, die in einem Temperaturinformationssignal spezifiziert wird, aus der Datentabelle erhält.

2. Elektronische Vorrichtung (11) nach Anspruch 1, wobei:
die elektronische Vorrichtung ferner einen Staubfänger (23) umfasst, welcher sich in einem Luftdurchgang befindet, der sich von der Ventilationsöffnung (48) aus erstreckt; und
die Abweichungs-Detektorschaltung (69) das vorbestimmte Signal ausgibt, um einen möglichen Verschluss der Ventilationsöffnung (48) oder die Ansammlung einer vorbestimmten Menge an Staub am Staubfänger (23) anzuzeigen.

## Revendications

1. Appareil électronique (11) comprenant :
un boîtier (18) ;
un ventilateur (43) enfermé dans le boîtier (18), lequel ventilateur (43) :
- a une ouverture de ventilation (48) pour le déchargement de l'air,
- génère un flux d'air par rotation d'un rotor (44), et
- comprend un ventilateur centrifuge ;
un circuit détecteur de vitesse de rotation (65) connecté au ventilateur (43), le circuit détecteur de vitesse de rotation (65) détectant une vitesse de rotation effective du rotor (44) ; et
un circuit détecteur d'écart (69) détectant un écart entre la vitesse de rotation effective et une vitesse de rotation désignée spécifiée dans un signal de commande envoyé au ventilateur (43), le circuit détecteur d'écart (69) émettant un signal prédéterminé indiquant une occlusion possible de l'ouverture de ventilation (48) lorsque la vitesse de rotation effective excède la vitesse de rotation désignée d'une quantité égale ou supérieure à un seuil ;
**caractérisé en ce que** l'appareil électronique comprend en outre :
un circuit de stockage comprenant une table de données (68), la table de données (68) contenant des valeurs de la vitesse de rotation désignée et le seuil pour diverses températures ; et
le circuit détecteur d'écart (69) obtient le seuil auprès de la table de données en fonction d'un niveau de température spécifié dans un signal d'information de température.

2. Appareil électronique (11) selon la revendication 1, dans lequel :
l'appareil électronique comprend en outre un capteur de poussière (23) situé dans un passage d'air s'étendant à partir de l'ouverture de ventilation (48) ; et
le circuit détecteur d'écart (69) émet le signal prédéterminé pour indiquer une occlusion possible de l'ouverture de ventilation (48) ou l'accumulation d'une quantité prédéterminée de poussière au niveau du capteur de poussière (23).
